# EUROPEAN PATENT APPLICATION

(11) **EP 2 639 665 A2**
(43) Date of publication of application: **18.09.2013**
(21) Application number: 13158573.9
(22) Date of filing: 11.03.2013
(51) Int. Cl.: G05D 23/19, F24F 11/00

(54) **Air-conditioning system**

(30) Priority: 13.03.2012 JP 2012055956
(71) Applicant: Mitsubishi Heavy Industries, Ltd., Tokyo 108-8215 (JP)
(72) Inventor: Kunita, Hiraku, Tokyo, 108-8215 (JP); Tsubono, Masahiro, Tokyo, 108-8215 (JP); Fujino, Tetsuji, Tokyo, 108-8215 (JP); Inaba, Takashi, Tokyo, 108-8215 (JP); Saegusa, Satoru, Tokyo, 108-8215 (JP)
(74) Representative: Intès, Didier Gérard André

(57) **Abstract**

Provided is an air-conditioning system 1 having air-conditioners 2 and 2A includes overload state detecting means 13 and 13A that calculate a temperature difference between a preset temperature and a detection value of a room temperature, and output an overload alarm signal when a state in which the temperature difference is a preset value or larger continues for a preset time period, warning means 14, 14A and 14B which warn of an overload state when the overload state detecting means 13 and 13A detect the overload state, and setting means 15 and 15A that are capable of setting the preset value and the preset time period.

## Description

### BACKGROUND OF THE INVENTION

### 1. FIELD OF THE INVENTION

The present invention relates to an air-conditioning system suitable for being applied to air conditioning of a computer room including a server room, for example, which needs to keep a room temperature constant all year round.

### 2. DESCRIPTION OF RELATED ART

In air conditioning of a server room or the like, the room temperature needs to be kept at a constant temperature all year round. The conventional air-conditioner is configured to output a failure signal to outside when a failure occurs. However, even if the room temperature is in a state significantly deviating from a preset temperature when the air-conditioning load increases, the conventional air-conditioner does not specially notify the outside of the deviation, because this state is not a failure.

In contrast with this, Japanese Unexamined Patent Application, Publication No. 2001-304648 discloses the air-conditioner which gives notification to the outside to call attention, correct a set temperature automatically and achieve energy saving, when the room temperature does not reach the preset temperature within a preset time period because the difference between the room temperature and the preset temperature is excessively large beyond the capacity of the heating and cooling conditioner, or due to leakage of air, or the like by a window, a door or the like being left open.

### BRIEF SUMMARY OF THE INVENTION

However, with the air-conditioner which is configured to give notification to the outside to call attention and correct the preset temperature automatically to achieve energy saving when the room temperature does not reach the preset temperature within the preset time period as described above, only the fact that the room temperature does not reach the preset temperature within the preset time period is known, and the air-conditioner is not intended to cope with the risk with respect to the situation in which the room temperature is not kept constant, based thereon.

That is to say, the air-conditioner is not configured to prompt correction by outputting a warning, or take a corrective action automatically when the room temperature and the preset temperature thereof do not satisfy the conditions which are set in advance based on the installation environment of the air-conditioner, and the risk assessment or the like of the user, or is not configured to be able to set such conditions at proper values based on the intention of the user. Under such situation, in the air-conditioners which are provided for air conditioning that keeps the room temperatures at constant temperatures all year round, reinforcement and enhancement of the functions of keeping the room temperatures constant are desired.

The present invention is made in the light of the above circumstances, and an object of the present invention is to provide an air-conditioning system which can reinforce and enhance the function of keeping a room temperature constant by an air-conditioner which is provided for air conditioning that keeps the room temperature at a constant temperature all year round.

In order to solve the problem described above, the air-conditioning system of the present invention adopts the following solutions.

An air-conditioning system having an air-conditioner according to the present invention includes an overload state detecting means that calculates a temperature difference between a preset temperature and a detection value of a room temperature, and outputs an overload alarm signal when a state in which the temperature difference is a preset value or larger continues for a preset time period, a warning means that warns of an overload state when the overload state detecting means outputs the overload alarm signal, and a setting means that is capable of setting the preset value and the preset time period.

According to the present invention, the overload state detecting means that calculates the temperature difference between a preset temperature and the detection value of a room temperature, and outputs an overload alarm signal when the state in which the temperature difference is a preset value or larger continues for a preset time period, the warning means that warns of an overload state when the overload state detecting means outputs the overload alarm signal, and the setting means that is capable of setting the preset value and the preset time period are included. Therefore, when a so-called overload state in which the room temperature significantly deviates from the preset temperature due to increase in an air-conditioning load continues in air conditioning that keeps the room temperature at a constant temperature all year round, for example, the overload state is detected by the overload state detecting means, and the overload alarm signal is outputted, whereby warning is given with the warning means provided in the remote controller, the remote operation/monitoring device, the integrated controller and the like or the exclusive warning means, and an operator or the like can be warned. Further, the preset temperature difference and the preset time period for detecting whether the overload state is brought about or not can be set at proper values via the remote controller in response to the installation environment or the like of the air-conditioner, the risk assessment of the user or the like. Accordingly, the function of keeping the room temperature constant of the air-conditioner which is provided for air conditioning that keeps the room temperature at a constant temperature all year round is reinforced and enhanced, and even if the overload state is detected, the room temperature environment can be kept by quickly eliminating the overload state.

Furthermore, in the air-conditioning system of the present invention, further includes a backup air-conditioner that is operable when the overload alarm signal is outputted from the overload state detecting means.

According to the present invention, when the overload alarm signal is outputted from the overload state detecting means, the backup air-conditioner is made operable. Therefore, when the overload state is detected, the air-conditioner for backup is automatically started to operate by using the overload alarm signal outputted from the overload state detecting means, and thereby can cope with the overload state. Accordingly, even at the time of the air-conditioning load increasing, the room temperature can be kept at the preset temperature, and can be kept at a constant temperature all year round.

Further, in the air-conditioning system of the present invention, the air-conditioner is an air-conditioner for a computer room including a server room and the like, in any one of the aforementioned air-conditioning systems.

According to the present invention, the air-conditioner is an air-conditioner for a computer room. Therefore, with use of such an air-conditioner, the computer room including a server room and the like can be air-conditioned at a constant temperature all year round. Accordingly, the heat load of the computers including a server and the like can be reduced, and the computers including a server can be always operated with the maximum capacities.

According to the present invention, when a so-called overload state in which the room temperature significantly deviates from the preset temperature due to increase in the air-conditioning load is continued in air conditioning that keeps the room temperature at a constant temperature all year round, for example, the overload state is detected with the overload state detecting means, and the overload alarm signal is outputted, whereby warning is given with the warning means provided in the remote controller, the remote operation/monitoring device, the integrated controller and the like or the exclusive warning means, and the operator or the like can be warned. Further, the preset temperature difference and the preset time period for detecting that the overload state is brought about or not can be set at proper values via the remote controller in response to the installation environment and the like of the air-conditioner, or based on the risk assessment or the like of the user. Therefore, the function of keeping the room temperature constant of the air-conditioner which is provided for the air-conditioning that keeps the room temperature at a constant temperature all year round is reinforced and enhanced, and even if the overload state is detected, the room temperature environment can be kept by quickly eliminating the overload state.

### BRIEF DESCRIPTION OF THE SEVERAL VIEWS OF THE DRAWINGS

FIG. 1 is a schematic configuration diagram of an air-conditioning system according to a first embodiment of the present invention;
FIG. 2 is a schematic configuration diagram of an air-conditioning system according to a second embodiment of the present invention; and
FIG. 3 is a schematic configuration diagram of an air-conditioning system according to a third embodiment of the present invention.

### DETAILED DESCRIPTION OF THE INVENTION

Hereinafter, embodiments according to the present invention will be described with reference to the drawings.

### [First embodiment]

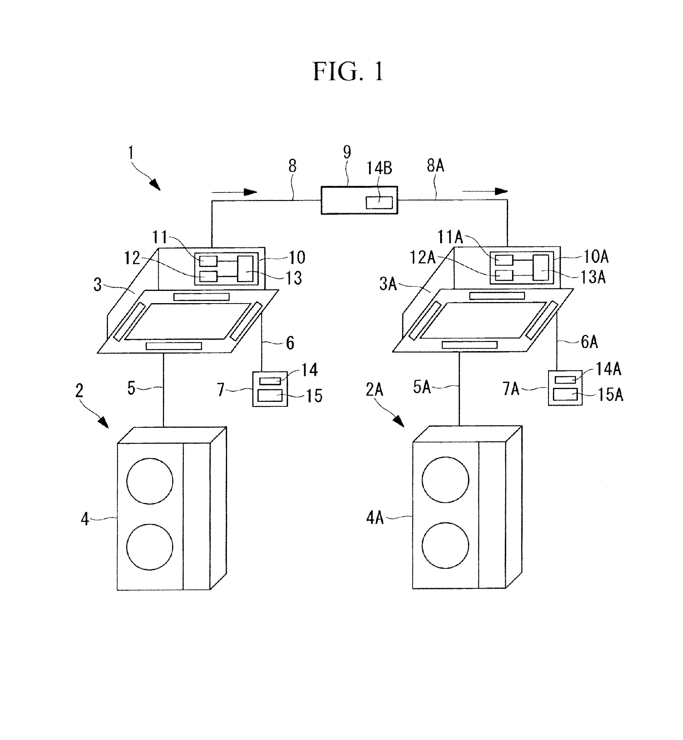

Hereinafter, a first embodiment of the present invention will be described with use of FIG. 1.

FIG. 1 shows a schematic configuration diagram of an air-conditioning system according to the first embodiment of the present invention.

An air-conditioning system 1 includes an air-conditioner 2 which is installed in a computer room or the like including a server room, for example, which needs to keep a room temperature at a constant temperature all year round, and an air-conditioner 2A for backup thereof. Note that the present embodiment adopts an example in which one of each of the air-conditioner 2 and the air-conditioner 2A for backup are installed. However, a plurality of each of the air-conditioner 2 and the air-conditioner 2A for backup may be installed as a matter of course.

The air-conditioners 2 and 2A are configured to include indoor units 3 and 3A which are installed at an indoor side, outdoor units 4 and 4A which are installed at an outdoor side, refrigerant pipes and internal-external communication lines 5 and 5A which connect the indoor units and the outdoor units, and remote controllers 7 and 7A which are connected to the indoor units 3 and 3A via remote control communication lines 6 and 6A. Further, the indoor units 3 and 3A are connected to a remote operation/monitoring device 9 via communication lines 8 and 8A, and are remotely controlled by not only the remote controllers 7 and 7A but also the remote operation/monitoring device 9.

The controllers 10 and 10A at the indoor units 3 and 3A sides are provided with room temperature sensors 11 and 11A which detect an indoor temperature Ta based on an intake air temperature, indoor temperature setting means 12 and 12A which set preset temperatures Ts/TsC by input from the remote controllers 7 and 7A, and overload state detecting means 13 and 13A which calculate a temperature difference between the detection value Ta by the temperature sensors 11 and 11A and preset temperatures Ts/TsC which are set by the room temperature setting means 12 and 12A, and transmit overload alarm signals to inspection/abnormality output (CNT-5) that is an output destination for controlling an unit external device, when a state in which the temperature difference is a preset value (ΔTalm) or larger continues for a preset time period (Halm).

Note that the overload state detecting means 13 and 13A are configured to output the overload alarm signals when the indoor temperature Ta, that is, the intake air temperature satisfies the following conditions after, for example, 30 minutes elapses after operation of the air-conditioner 2 is started, or after, for example, 30 minutes elapses after an operation mode is switched during operation.
(1) at the time of cooling, dehumidifying, and automatic cooling: the indoor temperature Ta is the preset temperature TsC +ΔTalm, or higher
(2) at the time of heating and automatic heating: the indoor temperature Ta is the preset temperature Ts -ΔTalm, or lower

Further, the remote controllers 7 and 7A and/or the remote operation/monitoring device 9 are provided with warning means 14, 14A and 14B which receive the overload alarm signals when the overload state detecting means 13 and 13A detect the overload states, flash or light warning lamps such as LEDs, and warn the operator or the like of the overload states. The warning means 14, 14A and 14B are not limited to lamps such as LED lamps, but various other means such as buzzers, sound, and music can be used as the warning means.

Furthermore, the remote controllers 7 and 7A are provided with setting means 15 and 15A for setting the threshold values (ΔTalm and Halm) of the temperature differences between the indoor temperature Ta and the preset temperatures Ts/TsC and the time period at proper values based on the installation environment of the air-conditioners 2 and 2A, the risk assessment of the user and the like. The setting means 15 and 15A set specific numeric values as the threshold values in such a manner that the above described temperature difference is certain degrees, and the time period is certain minutes, and can set proper values within a certain range in such a manner that, for example, the temperature difference is 5 to 10°, and the time period is 30 to 60 minutes.

The above described overload alarm signal is cleared when the following conditions are satisfied.
(1) at the time of cooling, dehumidifying and automatic cooling: the indoor temperature is the preset temperature TsC +ΔTalm - 2°C, or lower
(2) at the time of heating and automatic heating: the indoor temperature is the preset temperature Ts -ΔTalm + 2°C, or higher
(3) in the case of operation being stopped
(4) in the case of the operation mode being switched, in the case of the mode at the time of automatic operation being switched

Further, in the present embodiment, the air-conditioner 2A for backup is also provided with the overload state detecting means 13A and the setting means 15A. However, the air-conditioner 2A for backup in this case can perform backup operation based on the overload alarm signal when the operation state by the air-conditioner 2 is brought into an overload operation state, and does not always have to include the overload state detecting means 13A and the setting means 15A.

By the configuration described above, according to the present embodiment, the following operational effect is provided.

When the operation of the air-conditioners 2 and 2A is started in the above described air-conditioning system 1, the preset temperatures Ts/TsC are set via the remote controllers 7 and 7A, and the temperature difference preset values between the indoor temperature Ta and the preset temperatures Ts/TsC and the time period preset value (ΔTalm and Halm) are set as the threshold values by the setting means 15 and 15A which are provided at the remote controllers 7 and 7A. As for the temperature difference preset value (ΔTalm) and the time period preset value (Halm), the temperature and the time period are set based on the installation environment of the air-conditioners 2 and 2A, the risk assessment judged by the user and the like.

In a computer room including a server room and the like, heat generation takes place all year round, and the air-conditioner 2 mainly performs cooling operation. When the air-conditioning load abnormally increases, and the state in which the temperature difference between the room temperature detection value Ta detected by the room temperature sensor 11 and the preset temperature TsC which is set by the indoor temperature setting means 12 is the preset value (ΔTalm) or larger continues for a preset time period (Halm), the overload state detecting means 13 determines that the overload state is brought about, and outputs the overload alarm signal to the inspection/abnormality output (CNT-5) of the indoor controller 10.

The overload alarm signal is transmitted to the remote controller 7 and the remote operation/monitoring device 9 via the communication lines 6 and 8, actuates the warning means 14 and 14B which are provided in the remote controller 7 and the remote operation/monitoring device 9 to warn the operator or the like of the overload state. At the same time, the remote operation/monitoring device 9 outputs an operation signal to the air-conditioner2A for backup, and thereby the air-conditioner 2A for backup starts operation. Therefore, the overload state is quickly eliminated, and the computer room including a server room and the like is kept at a constant temperature all year round.

Consequently, according to the present embodiment, when the room temperature significantly deviates from the preset temperature due to increase in the air-conditioning load and the overload state continues, in air conditioning that keeps the room temperature at a constant temperature all year round, the overload state detecting means 13 (13A) detects this, and outputs an overload alarm signal to the outside, and thereby a warning is given via the warning means 14 and 14B provided at the remote controller 7 (7A) and/or the remote operation/monitoring device 9, so that an operator or the like can be warned thereof. Further, the preset temperature difference (ΔTalm) and the preset time period (Halm) for detecting whether or not the overload state is brought about can be set at proper values via the remote controller 7 (7A) in response to the installation environment and the like of the air-conditioners 2 and 2A, or based on the risk assessment or the like of the user.

Therefore, the functions of keeping the room temperature constant of the air-conditioners 2 and 2A which are provided for air conditioning that keeps the room temperature at a constant temperature all year round are reinforced and enhanced, and even if the overload state is detected, the overload state is quickly eliminated, whereby the room temperature environment can be kept.

Further, the configuration is adopted in which when the overload alarm signal is outputted from the overload state detecting means 13, the air-conditioner 2A for backup is started to operate via the remote operation/monitoring device 9 by the signal, and therefore, when the overload state is detected, the air-conditioner 2A for backup is automatically started to operate, and can cope with the overload state. Accordingly, at the time of increase in the air-conditioning load, the room temperature is also kept at the preset temperature, and can be kept at a constant temperature all year round.

In particular, by being applied to the air-conditioners 2 and 2A for a computer room including a server room, the computer room including the server room and the like can be air-conditioned at a constant temperature which is set all year round. As a result, the heat load of the computers including a server and the like is reduced, and the computers including a server can be always operated with the maximum capacities.

### [Second embodiment]

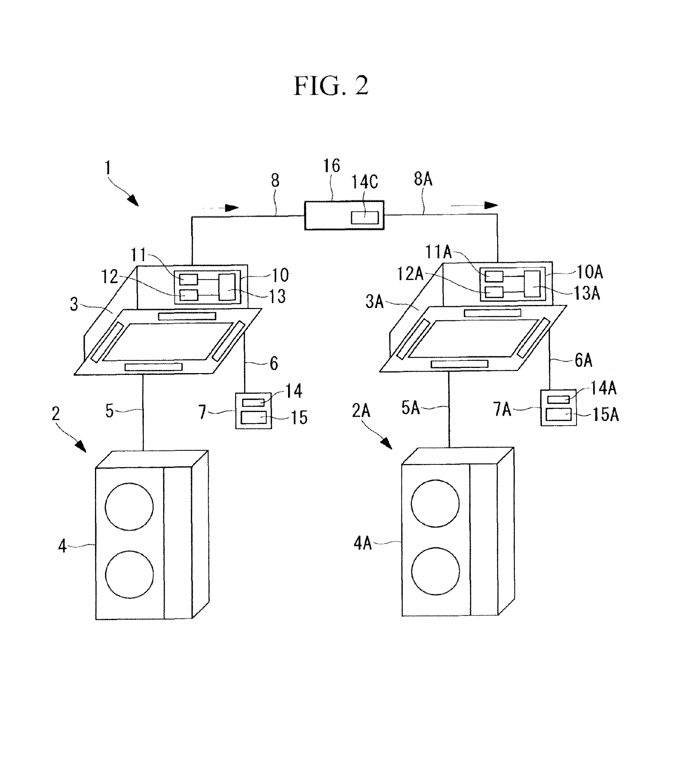

Next, a second embodiment of the present invention will be described with use of FIG. 2.

The present embodiment differs from the above described first embodiment in the feature of using an integrated controller 16 in place of the remote operation/monitoring device 9. The other features are the same as in the first embodiment, and therefore, the description thereof will be omitted.

The air-conditioning system 1 of the present embodiment includes the integrated controller 16 as shown in FIG. 2, and is configured such that the indoor controllers 10 and 10A of the air-conditioner 2 and the air-conditioner 2A for backup are connected to the integrated controller 16 via the communication lines 8 and 8A.

The integrated controller 16 includes warning means 14C, and includes a function of driving the air-conditioner 2A for backup by receiving an overload alarm signal when the overload alarm signal is outputted from the overload state detecting means 13, and operating the warning means 14C.

Consequently, according to the present embodiment, when the overload state is detected by the overload state detecting means 13, warning is given via the warning means 14, 14A and 14C which are provided in the remote controller 7 and/or the integrated controller 16 to be able to warn the operator or the like, and the operation of the air-conditioner 2A for backup is started, whereby the overload state can be eliminated, and the room temperature can be kept at a constant temperature all year round, similarly to the first embodiment.

### [Third embodiment]

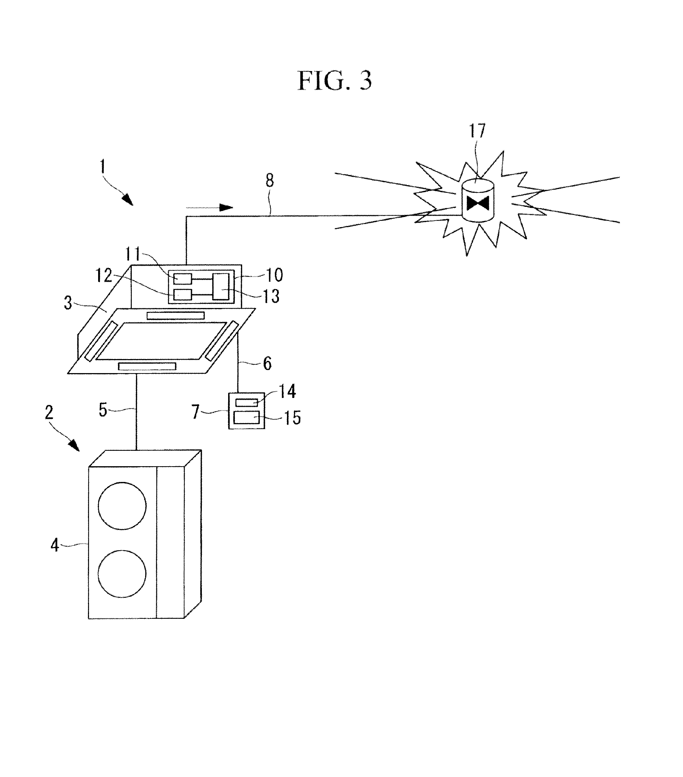

Next, a third embodiment of the present invention will be described with use of FIG. 3.

The present embodiment differs from the first embodiment and the second embodiment described above in the feature of including an exclusive external warning lamp 17, without including the air-conditioner 2A for backup. The other features are the same as in the first and the second embodiments, and therefore, the description thereof will be omitted.

In the present embodiment, when the overload state detecting means 13 provided at the indoor controller 10 of the air-conditioner 2 detects the overload state, an overload alarm signal thereof is configured to be directly outputted to the exclusive external warning lamp (warning means) 17 which is independently installed outside via the communication line 8, as shown in FIG. 3.

As described above, when the air-conditioner 2A for backup is not installed, the independent exclusive external warning lamp (warning means) 17 is installed at an external proper place, whereby when the overload state detecting means 13 detects that the overload state continues, the overload alarm signal from the overload state detecting means 13 is directly outputted to the external warning lamp 17 to operate the external warning lamp 17, and the operator can be warned. Thereby, early elimination of the overload state can be promoted, the function of keeping the room temperature constant can be reinforced and enhanced. It goes without saying that in this case, the preset temperature difference (ΔTalm) and the preset time period (Halm) for detecting whether the overload state is brought about or not can be also set at proper values via the remote controller 7 in response to the installation environment or the like of the air-conditioner 2, or based on the risk assessment or the like of the user.

Note that the present invention is not limited to the invention according to the above described embodiments, and can be properly modified within the range without departing from the gist of the present invention. For example, in each of the above described embodiments, the example in which the air-conditioner 2 is a single type air-conditioner with the indoor unit and the outdoor unit being in a one-to-one correspondence, but the air-conditioner may be a multiple type air-conditionerin which a plurality of indoor units are connected to an outdoor unit, as a matter of course.

### [REFERENCE SIGNS LIST]

| | |
|---|---|
| 1 | AIR-CONDITIONING SYSTEM |
| 2 | AIR-CONDITIONER |
| 2A | AIR-CONDITIONER FOR BACKUP |
| 3, 3A | INDOOR UNIT |
| 4, 4A | OUTDOOR UNIT |
| 7, 7A | REMOTE CONTROLLER |
| 9 | REMOTE OPERATION/MONITORING DEVICE |
| 10, 10a | INDOOR CONTROLLER |
| 11, 11A | ROOM TEMPERATURE SENSOR |
| 12, 12A | INDOOR TEMPERATURE SETTING MEANS |
| 13, 13A | OVERLOAD STATE DETECTING MEANS |
| 14, 14A, 14B, 14C | WARNING MEANS |
| 15, 15A | SETTING MEANS |
| 16 | INTEGRATED CONTROLLER |
| 17 | EXCLUSIVE EXTERNAL WARNING LAMP (WARNING MEANS) |

## Claims

1. An air-conditioning system (1) including an air-conditioner (2, 2A), **characterized in that** it comprises:
an overload state detecting means (13, 13A) that calculates a temperature difference between a preset temperature of the air-conditioner (2, 2A) and a detection value of a room temperature, and outputs an overload alarm signal when a state in which the temperature difference is a preset value or larger continues for a preset time period;
a warning means (14, 14A, 14B) that warns of an overload state when the overload state detecting means (13, 13A) outputs the overload alarm signal; and
a setting means (15, 15A) that is capable of setting the preset value and the preset time period.

2. The air-conditioning system according to claim 1, further comprising a backup air-conditioner (2A) that is operable when the overload alarm signal is outputted from the overload state detecting means (13, 13A).

3. The air-conditioning system (1) according to claim 1 or claim 2,
wherein the air-conditioner (2, 2A) is an air-conditioner for a computer room.

4. The air-conditioning system (1) according to any one of claims 1 to 3,
wherein the warning means (14, 14A, 14B) is provided at least one of a remote controller, a remote operation/monitoring device, and integrated controller.

5. The air-conditioning system (1) according to any one of claims 1 to 3,
wherein the warning means (14, 14A, 14B) is an exclusive warning means.
